# FASCICULE DE BREVET EUROPEEN

(11) **EP 0 639 912 B1**
(45) Date de publication et mention de la délivrance du brevet: **28.11.2001**
(21) Numéro de dépôt: 94401863.9
(22) Date de dépôt: 17.08.1994
(51) Int. Cl.: H04L 25/08, H03K 19/00, H03H 11/30

(54) **Procédé d'adaptation parallèle d'impédance pour un émetteur et/ou récepteur, circuit intégré et système de transmission le mettant en oeuvre**
Verfahren zur Parallelimpedanzanpassung für einen Sender und/oder Empfänger, sowie eine integrierte Schaltung und ein Übertragungssystem zur Durchführung des Verfahrens
Method for parallel impedance matching of a transmitter and/or receiver and integrated circuit and transmission system for implementing the method

(30) Priorité: 19.08.1993 FR 9310106
(43) Date de publication de la demande: 22.02.1995
(73) Titulaire: BULL S.A., 78430 Louveciennes (FR)
(72) Inventeur: Marbot, Roland, F-78000 Versailles (FR); Le Bihan, Jean-Claude, F-92120 Montrouge (FR); Cofler, Andrew, F-75015 Paris (FR); Nezamzadeh-Moosavi, Reza, F-78390 Bois d'Arcy (FR)
(74) Mandataire: Denis, Hervé

(56) Documents cités:
- EP-A- 0 463 316
- EP-A- 0 482 392
- EP-A- 0 520 687

## Description

L'invention se rapporte à un procédé d'adaptation parallèle d'impédance pour un émetteur et/ou un récepteur, ainsi qu'au circuit intégré et au système de transmission le mettant en oeuvre.

L'intégration d'un émetteur et d'un récepteur communiquant à travers une ligne de transmission pose deux problèmes majeurs. Le premier problème tient au débit de la ligne de transmission. On sait que pour les hautes fréquences on utilise une ligne de transmission déterminée par son impédance caractéristique couramment appelée Zc et assimilée à la résistance équivalente. La ligne est connectée à ses deux extrémités à deux amplificateurs respectifs, nommés tampons. Le tampon d'entrée amplifie la puissance des signaux à transmettre et le tampon de sortie remet en forme les signaux reçus et les amplifie pour être correctement traités par le récepteur. D'autre part, la transmission de signaux binaires se fait selon divers codages marqués par des fronts montants et descendants alternés selon des durées variables dans des proportions pouvant être supérieures à dix. Dans le domaine du gigabaud, les signaux de transmission peuvent varier dans une bande de fréquences dépassant 500 MHz. Cependant, chaque rapport cyclique doit être transmis sans déformation pour assurer l'intégrité et la fidélité de la transmission. Cela nécessite que le temps de traversée de chaque tampon doit être fixe, quelles que soient la fréquence de transmission dans la bande requise, la forme d'onde et la qualité des fronts montants et descendants.

Le deuxième problème tient en la technologie de fabrication des circuits intégrés. La technologie bipolaire offre l'avantage d'avoir des caractéristiques assez stables, mais elle consomme beaucoup d'énergie. La technologie des transistors à effet de champ consomme moins, surtout celle à transistors complémentaires comme par exemple la technologie CMOS, mais elle présente une grande dispersion des caractéristiques entre les mêmes composants de deux circuits intégrés différents. Il s'agit donc dans ce cas de rendre le fonctionnement de l'émetteur et du récepteur pratiquement insensible à cette dispersion. En outre, il est souhaitable que le dispositif de transmission soit indépendant de la technologie adoptée pour la fabrication de l'émetteur et du récepteur. Par exemple, un récepteur fait en technologie MOS devrait recevoir tout aussi bien les signaux émis par un émetteur de technologie MOS ou de technologie bipolaire, par exemple du type ECL (Emitter-Coupled Logic) caractérisé par une faible excursion des signaux de sortie qui est typiquement de 0,8 volt. L'invention vise à résoudre le premier problème, et plus particulièrement dans le contexte difficile du second problème que pose la dispersion des caractéristiques et la compatibilité des technologies de fabrication, en appliquant un procédé d'adaptation d'impédance.

Il est bien connu que l'adaptation d'impédance pour la transmission d'ondes électromagnétiques peut se faire en série ou en parallèle. L'adaptation série consiste à adapter l'impédance de sortie de l'émetteur sur l'impédance caractéristique de la ligne, en laissant ouverte son extrémité proche du récepteur. Cette adaptation a l'avantage de ne pas nécessiter de consommation statique. Cependant, elle a l'inconvénient d'être très sensible aux variations d'impédance sur la ligne et de véhiculer des signaux de grande amplitude (full swing). Il en résulte une grande consommation dynamique et une bande passante réduite, malgré l'avantage de ne pas avoir à amplifier le signal de réception. Enfin, on a vu que notamment l'impédance de sortie de l'émetteur est mal définie lors des commutations, de sorte que l'adaptation ne peut pas être optimisée et varie en fonction des conditions d'utilisation.

Un exemple d'adaptation série d'impédance est décrit dans le document EP-A-0 520 687. Ce document se rapporte d'une manière générale à un dispositif de commande numérique de la taille d'un transistor. Selon un mode de réalisation, un circuit émetteur a une structure similaire à celle d'un inverseur CMOS, faite de deux transistors complémentaires en série entre deux potentiels d'alimentation et dont le point commun est connecté à une ligne de transmission. La taille d'un premier de ces transistors est adaptée à l'impédance caractéristique de la ligne en reproduisant le transistor dans un pont de Wheatstone incluant une résistance de référence représentative de l'impédance caractéristique de la ligne de façon à avoir la taille du transistor reproduit, et à asservir la taille dudit premier transistor du circuit émetteur sur la taille du transistor reproduit dans le pont de Wheatstone. La taille du second transistor du circuit émetteur est adaptée à l'impédance caractéristique de la ligne en reproduisant les premier et second transistors dans un second pont de Wheatstone incluant une seconde résistance de référence, en asservissant la taille du premier transistor de ce second pont de Wheatstone à celle du premier transistor reproduit dans le premier pont de Wheatstone, en déterminant dans le second pont de Wheatstone la taille du second transistor reproduit, et en asservissant la taille du second transistor du circuit émetteur sur la taille du second transistor reproduit.

L'adaptation parallèle consiste à adapter l'impédance d'entrée du récepteur sur l'impédance caractéristique de la ligne. Elle a l'avantage de s'appliquer sur une large bande de fréquences, mais elle a le double inconvénient d'impliquer couramment une consommation statique et d'utiliser à la sortie de la ligne un signal ayant une excursion réduite. De plus, l'adaptation de l'impédance d'entrée du récepteur à l'impédance caractéristique de la ligne est une opération difficile, car la transmission-des signaux entre circuits intégrés a l'inconvénient d'avoir une structure hétérogène. Le câble coaxial de la ligne de transmission est souvent raccordé de chaque côté, par l'intermédiaire d'un connecteur coaxial, à un circuit imprimé équipé du boîtier incorporant dans un circuit intégré l'émetteur ou le récepteur. L'impédance de la connexion du câble coaxial au circuit intégré varie donc beaucoup et crée une réactance parasite. Cependant, il est souhaitable de maintenir l'impédance caractéristique sur la plus grande longueur possible de chaque ligne de transmission. Une solution courante à ce problème consiste à adapter l'impédance d'entrée du récepteur à l'impédance caractéristique de la ligne de transmission en connectant une résistance d'adaptation en bout de ligne. Cette résistance doit avoir une valeur fixe et précise, de 50 ohms ordinairement. Dans la technologie MOS, les dérives technologiques entre circuits intégrés font qu'il n'est pas possible d'intégrer une telle résistance. La résistance d'adaptation est donc placée à l'extérieur du circuit intégré, au plus près de lui. Mais la pratique révèle que même sans réactance et si on arrive à maintenir l'impédance caractéristique sur toute la longueur de la ligne, une longueur non négligeable de la ligne n'est pas adaptée si, aux fréquences élevées qui sont prévues (de l'ordre de plusieurs GHz), la résistance d'adaptation est placée avant d'entrer dans le circuit intégré. Une autre possibilité consiste à entrer dans le circuit intégré et à en ressortir pour placer la résistance d'adaptation en bout de ligne, à l'extérieur du circuit intégré. Mais cette solution a l'inconvénient de nécessiter deux bornes de sortie au lieu d'une par ligne, en plus de l'implantation sur le circuit intégré d'autant de résistances que de lignes. En outre, la réactance parasite sur chaque ligne serait doublée.

Un exemple d'adaptation parallèle est aussi décrit dans le document précité EP-A-0 520 687. Cet exemple est conforme à la solution classique consistant à ajuster une résistance d'entrée d'un circuit sur l'impédance caractéristique de la ligne. L'ajustement est fait avec l'aide d'un pont de Wheatstone, de la même façon que celle décrite précédemment.

Le document EP-A-0 463 316 décrit un dispositif d'adaptation d'impédance auto-ajustable pour circuit numérique, incluant une porte de montée et une porte de descente montées en parallèle avec des portes sélectionnées pour compenser toute dérive d'impédance.

Le document EP-A-0 482 392 décrit un circuit à courant constant utilisant un comparateur de la tension de sortie détectée par rapport à une tension de référence pour régler le courant de sortie. Le réglage est fait par un circuit à trajets de courant parallèles contenant chacun une résistance de charge et commutés indépendamment en l'onction du courant de sortie désiré.

La solution faisant l'objet de la présente invention consiste en un procédé d'adaptation parallèle d'impédance capable de satisfaire de manière correcte et fiable à toutes les contraintes posées par les deux problèmes précités.

L'invention a pour premier objet un procédé d'adaptation parallèle d'impédance tel que défini par la revendication 1.

L'invention a pour second object un procédé d'adaptation parallèle d'impédance tel que défini par la revendication 12.

Il en résulte un circuit intégré tel que défini par la revendication 15.

L'invention a encore pour objet un système de transmission, tel que défini par la revendication 16.

L'invention ressort mieux de la description qui suit d'exemples illustratifs de l'invention se référant aux dessins annexés.

Dans les dessins :
- la figure 1 est une vue synoptique d'un dispositif d'adaptation d'impédance conforme à l'invention, connecté à au moins un émetteur-récepteur incorporé dans un circuit intégré illustré de façon fragmentaire ;
- la figure 2 illustre schématiquement un exemple de réalisation d'un dispositif d'adaptation d'impédance conforme à l'invention ;
- la figure 3 illustre schématiquement un exemple de réalisation d'un émetteur relié au dispositif d'adaptation d'impédance représenté sur la figure 2 pour être adapté à l'impédance caractéristique d'une ligne de transmission selon le procédé d'adaptation d'impédance conforme à l'invention ;
- la figure 4 illustre schématiquement un exemple de réalisation d'un récepteur relié au dispositif d'adaptation d'impédance représenté sur la figure 2 pour être adapté à l'impédance caractéristique d'une ligne de transmission selon le procédé d'adaptation d'impédance conforme à l'invention ;
- la figure 5 est un graphe illustrant la caractéristique typique de transfert entrée-sortie d'un inverseur CMOS utilisé comme exemple d'amplificateur dans l'émetteur et le récepteur représentés sur les figures 3 et 4 ;
- la figure 6 illustre un montage servant de base à l'exemple de réalisation de l'émetteur-récepteur représenté sur les figures 3 et 4 ;
- les figures 7A, 7B et 7C illustrent trois variantes de réalisation d'un pont résistif en technologie CMOS ;
- la figure 8 est un graphe illustrant les caractéristiques statiques d'un transistor MOS monté de la façon décrite dans chacun des exemples représentés sur les figures 7A, 7B et 7C ;
- la figure 9 est un schéma de principe de l'adaptation d'impédance de l'émetteur et du récepteur illustrés dans les figures 3 et 4; et
- la figure 10 illustre de façon synoptique un exemple de système de transmission formé de circuits intégrés mettant en oeuvre l'invention, tels que celui illustré partiellement et de façon synoptique dans la figure 1.

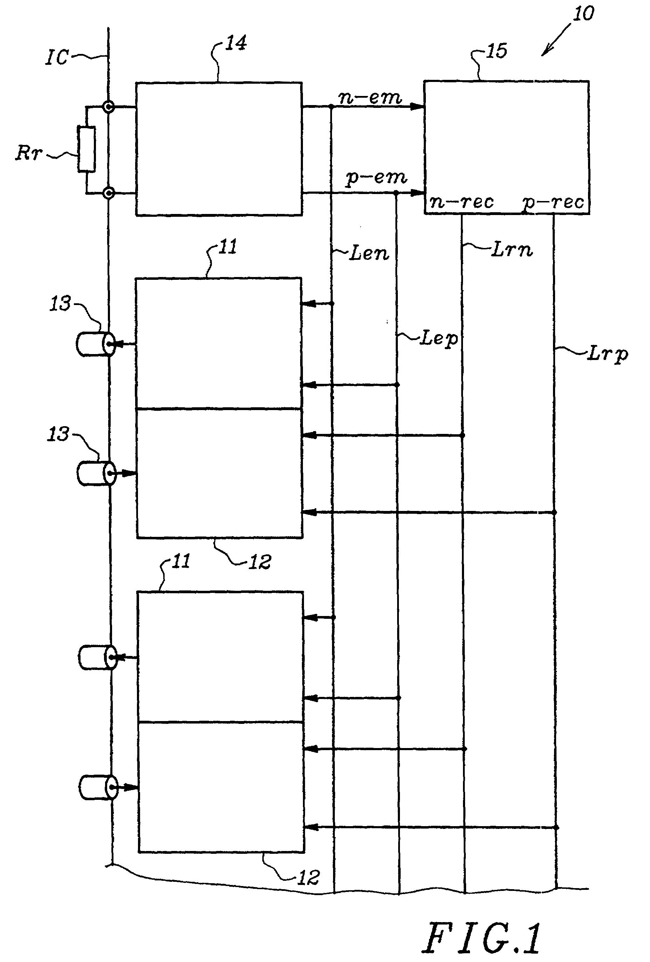

La figure 1 illustre partiellement et de façon synoptique un circuit intégré IC incorporant un dispositif d'adaptation d'impédance 10 pour au moins un émetteur-récepteur (transceiver) contenu dans le circuit intégré et composé d'un émetteur 11 et d'un récepteur 12.

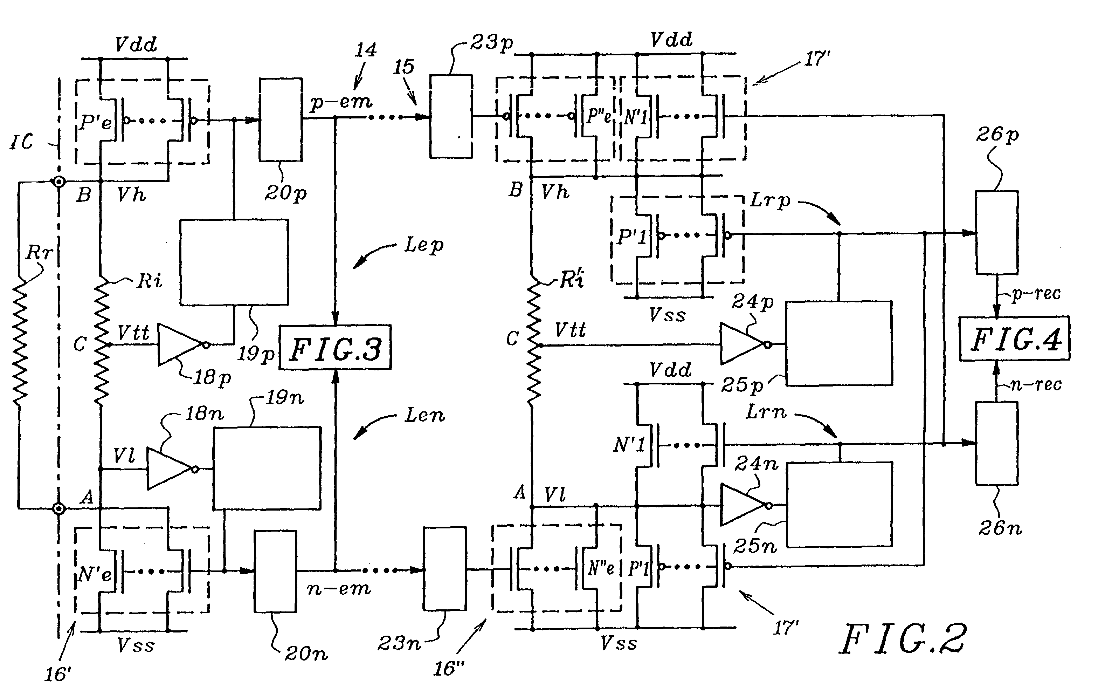

L'émetteur 11 et le récepteur 12 sont connectés à deux lignes respectives de transmission 13 unidirectionnelles ayant une impédance caractéristique Zc, ordinairement de 50 ohms. Dans l'exemple illustré, le dispositif 10 comprend un bloc d'adaptation d'impédance 14 pour tous les émetteurs 11 et un bloc d'adaptation d'impédance 15 pour tous les récepteurs 12. Le dispositif 10 et les émetteurs-récepteurs 11, 12 du circuit intégré IC choisi à titre d'exemple sont faits en technologie CMOS et opèrent sous deux potentiels d'alimentation Vss et Vdd représentés sur les figures 2, 3 et 4, respectivement la masse et +3,3 volts dans le mode de réalisation qui va être décrit.

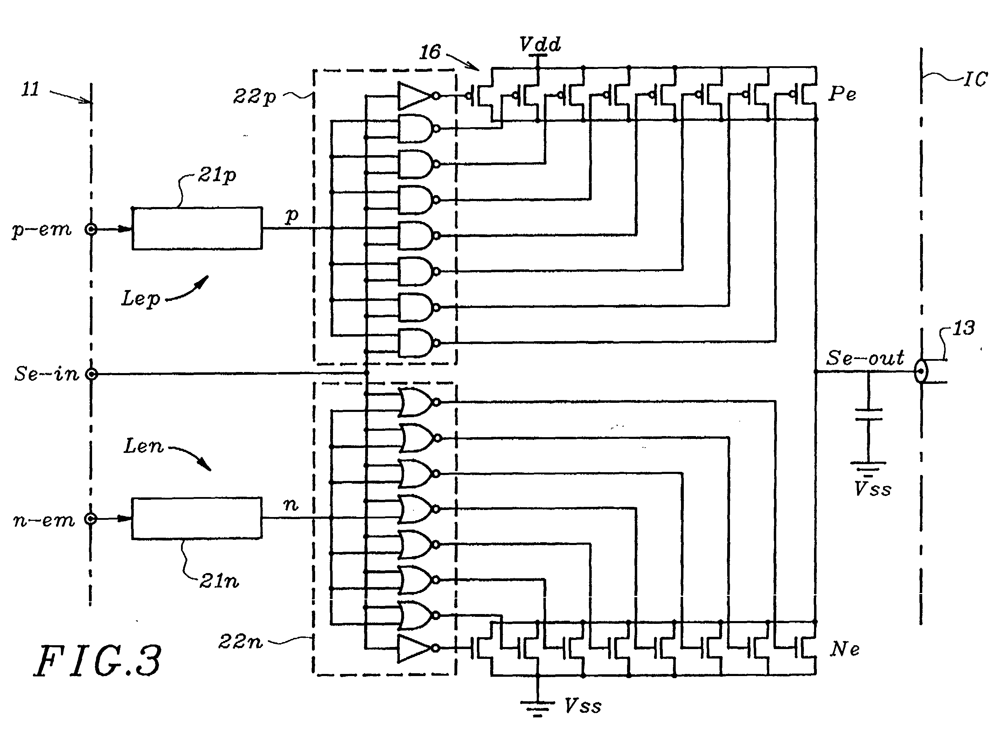

En ce qui concerne l'émetteur 11 représenté sur la figure 3, il a été choisi de le faire à partir d'une structure d'émission 16 correspondant à un inverseur CMOS classique à transistors Ne et Pe montés en série entre les potentiels d'alimentation Vdd et Vss. Dans la structure illustrée, les transistors Ne et Pe constituent respectivement deux groupes de huit et dans lesquels ils ont leurs trajets de courant drain-source en parallèle. Leurs grilles sont prévues pour recevoir sélectivement le signal d'entrée d'émission Se-in et leurs drains sont connectés à l'une des lignes de transmission 13 pour lui fournir le signal de sortie d'émission Se-out.

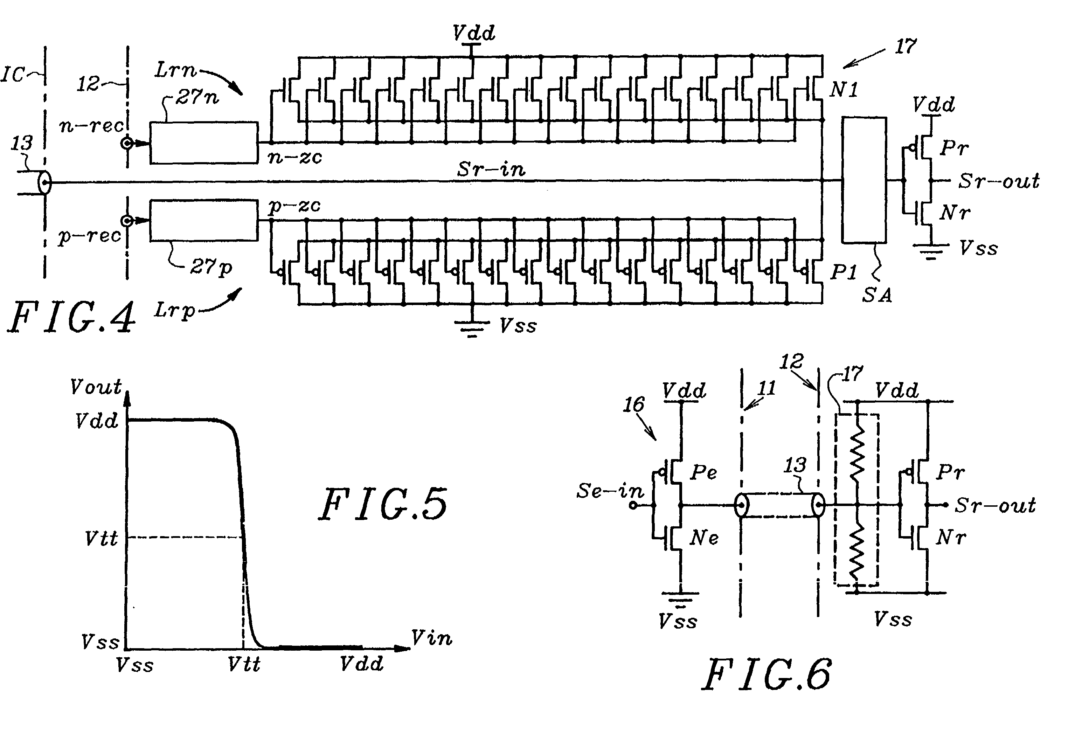

En ce qui concerne le récepteur 12 représenté sur la figure 4, il a été choisi de le faire aussi à partir d'un inverseur CMOS classique à transistors Nr et Pr montés en série entre les potentiels d'alimentation Vdd et Vss. Leurs grilles reçoivent en commun le signal d'entrée de réception Sr-in de l'une des lignes de transmission 13 et leurs drains communs délivrent le signal de réception de sortie Sr-out. Le procédé de l'invention consistant à faire une adaptation parallèle, il a été aussi choisi de déterminer l'impédance d'entrée du récepteur 12 au moyen d'un pont résistif 17 et d'adapter cette impédance à l'impédance caractéristique de la ligne 13. Le pont résistif 17 est formé de deux résistances ajustables montées en série entre les potentiels d'alimentation Vdd et Vss et dont le point commun est relié aux grilles des transistors Nr et Pr, de préférence par l'intermédiaire d'un amplificateur de mise en forme SA du signal d'entrée de réception Sr-in. Dans l'exemple illustré, les résistances ajustables sont faites de groupes respectifs de seize transistors N1 et P1 montés en parallèle et sélectionnés par activation de leurs grilles. Les transistors N1 sont directement connectés au potentiel Vdd et les transistors P1 sont directement connectés au potentiel Vss.

Le bloc d'adaptation d'impédance 14 de l'exemple illustré dans la figure 2 comprend une structure de référence d'émission 16' reproduisant la structure d'émission 16 de l'émetteur 11. La structure de référence d'émission 16' illustrée comprend donc deux groupes respectifs de huit transistors N'e, P'e montés en série entre les potentiels Vdd et Vss. Leurs grilles sont aussi sélectivement activées dans chaque groupe. Les drains des deux groupes de transistors N'e et P'e sont connectés à deux points respectifs A et B. La structure 16' comprend en outre une résistance de référence Rr connectée aux points A et B. La résistance de référence Rr doit avoir une valeur précise prédéterminée, ne pouvant pas être obtenue d'une résistance intégrée dans le circuit intégré IC. La résistance Rr est donc une résistance non intégrée, dite par conséquent extérieure au circuit intégré IC. Dans l'exemple choisi, elle vaut le double de l'impédance caractéristique Zc des lignes de transmission 13 et vaut donc en l'occurrence 100 ohms. On appelle le potentiel bas VI au point A et le potentiel haut Vh au point B. La structure 16' comprend aussi une résistance intermédiaire Ri connectée aussi entre les points A et B et ayant au moins une valeur de 2000 ohms pour influer de manière négligeable sur la valeur de la résistance de référence Rr. La résistance intermédiaire Ri est intégrée au circuit IC et sert à mesurer le potentiel Vtt en son point milieu C.

Le bloc 14 comprend, en plus de la structure 16', deux boucles d'asservissement Len et Lep. Dans la boucle Len, le potentiel Vl au point A est appliqué à l'entrée d'un comparateur 18n pour être comparé avec le potentiel désiré de Vl. Le signal de différence à la sortie du comparateur 18 est appliqué à l'entrée d'un circuit de sélection 19n, dont la sortie active les grilles des transistors N'e sélectionnés et est aussi appliquée à un codeur 20n. Le codeur 20 délivre un signal de commande n-em à une borne de sortie du bloc 14. De même, dans la boucle Lp le potentiel Vtt au point C est appliqué à l'entrée d'un comparateur 18p pour être comparé avec la valeur désirée du potentiel Vtt. Le signal de différence à la sortie du comparateur 18p est appliqué à l'entrée d'un circuit de sélection 19p, dont la sortie active les grilles des transistors P'e sélectionnés et est aussi appliquée à un codeur 20p. Le codeur 20p délivre un signal de commande p-em à une borne de sortie du bloc 14. Dans l'exemple illustré, les deux codeurs 20n et 20p déterminent des valeurs moyennes des signaux de sélection et codent les deux valeurs moyennes pour fournir les signaux de commande n-em et p-em codés sous forme de trois bits [0:2].

Comme indiqué dans les figures 1, 2 et 3, les signaux de commande n-em et p-em dans les boucles d'asservissement d'émission Len et Lep sont appliqués à deux entrées de commande de l'émetteur 11. Les deux signaux de commande n-em et p-em sont appliqués à des décodeurs respectifs 21n et 21p délivrant des signaux de sélection n et p, de huit bits en l'occurrence [0:7]. Les boucles Len et Lep comprennent aussi deux circuits respectifs de sélection 22n et 22p pour sélectionner les transistors Ne et Pe en réponse aux signaux n et p. Le circuit de sélection 22n illustré comprend sept portes NOR à deux entrées et un inverseur, dont les sorties sont connectées aux grilles respectives des huit transistors Ne. L'entrée de l'inverseur et une entrée des sept portes NOR reçoivent le signal d'entrée Se-in tandis que l'autre entrée des sept portes NOR reçoit le signal de sélection n. Le circuit de sélection 22p illustré est fait de sept portes NAND à deux entrées et d'un inverseur, dont les sorties sont connectées aux grilles respectives des huit transistors Pe. L'entrée de l'inverseur et une entrée des sept portes NAND reçoivent le signal d'entrée Se-in tandis que l'autre entrée des sept portes NAND reçoit le signal de sélection p.

Les signaux de commande d'émetteur n-em et p-em sont aussi appliqués sur deux entrées de commande du bloc d'adaptation d'impédance 15 du récepteur 12, représenté sur les figures 1 et 2. Le bloc 15 comprend une structure 16" similaire à la structure 16' du bloc 14 et composée de deux groupes de huit transistors N"e et P'e identiques aux groupes N'e et P'e, connectés aux potentiels d'alimentation respectifs Vss et Vdd et reliés en série entre des points A et B par une résistance intermédiaire R'i identique à la résistance Ri. Les signaux de commande n-em et p-em sont décodés dans des décodeurs respectifs 23n et 23p pour ajuster les groupes de transistors N"e et P"e de la même façon que les groupes N'e et P'e du bloc 14. Par conséquent, les potentiels Vl et Vtt aux points A et C sont identiques à ceux du bloc 14. Ces potentiels servent de référence pour deux boucles Lrn et Lrp pour l'asservissement des résistances N1 et P1 du pont résistif 17 du récepteur 12. Le bloc 15 comprend donc en outre deux ponts résistifs 17' identiques au pont 17 et donc composés chacun du montage en série de deux groupes de seize transistors N' 1 et P' 1 entre les potentiels d'alimentation Vdd et Vss. Les seize transistors N'1 des deux ponts 17' sont montés en parallèle entre le potentiel Vdd et les points respectifs A et B de la structure 16', tandis que les seize transistors P'1 des deux ponts sont montés en parallèle entre le potentiel Vss et les points respectifs A et B. Dans chaque groupe, les transistors N'1 et P'1 sont sélectivement activés par leurs grilles.

Dans les deux boucles de récepteur Lrn et Lrp, les potentiels Vl et Vtt aux points A et C du bloc 15 sont appliqués aux entrées respectives de deux comparateurs 24n et 24p pour être comparés avec les valeurs désirées de V1 et Vtt correspondantes. Les signaux de sortie des comparateurs 24n et 24p sont appliquées aux entrées respectives de deux circuits d'ajustement 25n et 25p, dont les sorties respectives activent sélectivement les grilles des transistors N' 1 et P'1 et sont appliquées aux entrées de deux codeurs 26n et 26p délivrant à deux bornes de sortie de commande du bloc 15 des signaux codés n-rec et p-rec représentatifs des valeurs moyennes de sélection des transistors N' 1 et P'1.

Comme indiqué dans les figures 1 et 4, les signaux de commande n-rec et p-rec des deux boucles Lrn et Lrp sont appliqués sur deux bornes d'entrée de commande du récepteur 12. Les deux entrées de commande sont connectées à deux décodeurs respectifs 27n et 27p fournissant des signaux de sélection n-zc et p-zc, de 16 bits chacun, pour activer les transistors N1 et P1 du pont 17 de la même façon que les transistors N' 1 et P' des ponts 17' du bloc 15.

Le fonctionnement du système de transmission 10 qui vient d'être décrit à titre d'exemple en référence aux figures 1 à 4 va maintenant être présenté. Il est d'abord important de préciser que cet exemple a été conçu pour satisfaire à la fois à cinq conditions, et que ces conditions ont été prises à titre d'exemple très contraignant afin de mettre en relief les caractéristiques et les avantages de l'invention. En d'autres termes, ces conditions peuvent être changées pour être plus ou moins contraignantes, et ne sont pas nécessairement cumulatives comme dans l'exemple choisi. Par exemple, une ou plusieurs seulement peuvent être prises parmi les conditions énoncées et/ou d'autres encore du domaine de l'homme du métier.

Les cinq conditions à satisfaire sont :
(1) concevoir un amplificateur CMOS ayant large bande passante et conservant le rapport cyclique,
(2) adapter l'impédance d'entrée du récepteur,
(3) concevoir l'émetteur pour maintenir constante l'excursion de tension sur la ligne de transmission afin de pouvoir garantir les performances de la transmission,
(4) garantir une bonne immunité aux bruits sur la ligne et une bonne réjection de mode commun due aux différences de tension pouvant exister entre les tensions d'alimentation Vdd et Vss de l'émetteur et du récepteur, et
(5) assurer une compatibilité des niveaux d'entrée-sortie avec les composants ECL afin de fonctionner avec des circuits de couplage optique.

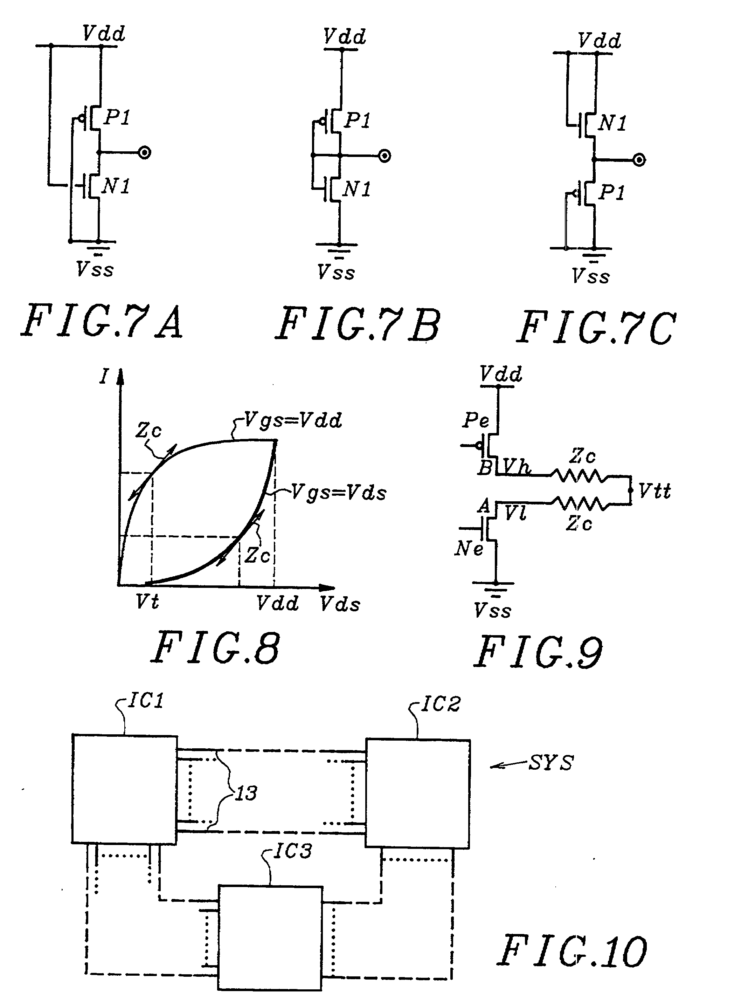

Pour résoudre le point (1), il a été jugé que le meilleur et le plus simple amplificateur actuel en technologie CMOS est l'inverseur composé de deux transistors complémentaires montés en série entre les tensions d'alimentation Vdd et Vss, dont les grilles communes reçoivent le signal d'entrée et les drains communs délivrent le signal de sortie, tel que l'inverseur 34 de la figure 4. Cet inverseur a une caractéristique de transfert entrée-sortie du type représenté sur la figure 5. Le graphe de la figure 5 représente les variations du potentiel de sortie Vout en fonction de la variation du potentiel d'entrée Vin de l'inverseur. Les potentiels Vin et Vout varient entre les potentiels d'alimentation Vss et Vdd. Il apparaît que cet inverseur est un amplificateur uniquement dans une partie (appelée plage) du potentiel d'entrée Vin dans laquelle le potentiel de sortie Vout varie entre Vss et Vdd. Cependant, les dispersions résultant de la fabrication des circuits intégrés font que cette plage est plus ou moins grande selon les circuits intégrés. Par conséquent, les distorsions d'amplification sont évitées si l'entrée de l'inverseur est polarisée à un potentiel Vtt correspondant au milieu de la plage d'amplification ainsi qu'au milieu des potentiels d'alimentation Vdd et Vss. Cette polarisation peut être simplement faite par un diviseur potentiométrique, ou pont résistif, qui peut avantageusement constituer aussi l'impédance d'adaptation Zc du récepteur. Le schéma de principe de ce montage est illustré dans la figure 6. Dans cette figure, l'émetteur 11 comprend l'inverseur 16 constitué des deux transistors complémentaires Ne et Pe dont les grilles reçoivent le signal d'entrée d'émission Se-in et dont les drains délivrent le signal de sortie d'émission Se-out à la ligne de transmission 13. Le récepteur 12 comprend l'inverseur constitué des deux transistors complémentaires Nr et Pr dont les grilles reçoivent de la ligne 13 le signal d'entrée de réception Sr-in et dont les drains reçoivent le signal de sortie de réception Sr-out. Les grilles des transistors Nr et Pr sont aussi connectées au point de jonction des deux résistances N1 et P1 montées en série entre les tensions Vdd et Vss et constituant le pont résistif 17. Il apparaît donc que si l'entrée du récepteur 12 est en l'air, l'inverseur Nr, Pr est polarisé dans sa plage d'amplification tandis que sa sortie est voisine du potentiel Vtt.

D'autre part, l'émetteur 11 doit fournir sur la ligne 13 un signal le plus symétrique possible. Les transistors Ne et Pe sont alternativement conducteurs pour passer les alternances positives et négatives du signal de sortie d'émission Se-out. Si les transistors Ne et Pe étaient de pures sources de courant commutables, la transmission serait alors indépendante de l'alimentation continue de l'émetteur par les potentiels Vdd et Vss et serait par conséquent indépendante des différences des valeurs des potentiels d'alimentation Vdd et Vss entre l'émetteur 11 et le récepteur 12. L'inverseur 16 assurerait donc une totale réjection de mode commun. Mais en pratique, les transistors Ne et Pe ne sont pas de pures sources de courant commutables et n'assurent donc pas une totale réjection de mode commun d'alimentation. Elle reste cependant très bonne et très satisfaisante. Une solution qui assurerait une totale réjection de mode commun d'alimentation consisterait à utiliser une transmission différentielle. Dans le cadre de l'exemple de réalisation en technologie CMOS prévue pour un emploi à très large bande passante, les caractéristiques des transistors MOS rendent impossibles la réalisation d'un tel amplificateur différentiel CMOS. Il est clair cependant que cette solution pourrait être utilisée dans une autre technologie ou pour satisfaire à des conditions moins contraignantes que celles choisies.

Le montage de principe de la figure 6 satisfait donc quatre des cinq conditions précitées. En bref, il offre la plus large bande passante possible dans la technologie choisie, il adapte l'entrée du récepteur à l'impédance caractéristique de la ligne et assure une excursion de tension constante sur la ligne. Il assure aussi une bonne réjection de mode commun d'alimentation à la condition que (a) le pont résistif 17 d'entrée du récepteur présente une impédance équivalente égale à l'impédance caractéristique Zc de la ligne 13 et que l'entrée du récepteur soit placée à un potentiel de polarisation égal au seuil Vtt de commutation de l'inverseur Nr, Pr et (b) que les transistors de sortie Ne et Pe de l'émetteur 11 soient dimensionnés pour fournir une excursion de tension prédéterminée et symétrique autour du potentiel de polarisation Vtt quand la charge de sortie a une impédance égale à l'impédance caractéristique Zc de la ligne. Les conditions (a) et (b) sont satisfaites dans l'exemple illustré en constituant les résistances du pont résistif 17 au moyen des transistors CMOS N1 et P1, comme illustré dans la figure 4, et en asservissant les transistors N1 et P1 ainsi que les transistors Ne et Pe de l'émetteur. Dans l'exemple choisi, les résistances N1 et P1 du récepteur 12 et l'amplificateur de sortie 16 de l'émetteur 11 sont respectivement faits de groupes de transistors montés en parallèle et activés sélectivement et simultanément par un dispositif d'asservissement incorporé dans le circuit intégré IC et satisfaisant aux conditions (a) et (b). Le dispositif d'asservissement se compose donc des deux boucles Len et Lep pour l'asservissement des transistors Ne et Pe de l'amplificateur d'émission et des deux boucles Lrn et Lrp pour l'asservissement des transistors N1 et P1 du pont résistif du récepteur. En outre, pour satisfaire aux conditions (a) et (b), il est soumis, dans l'exemple de réalisation, à quatre conditions corollaires des conditions précitées :
- le potentiel de polarisation du pont résistif doit être égal au seuil de commutation Vtt d'un inverseur identique à l'amplificateur de réception Nr, Pr, c'est-à-dire réalisé dans la même technologie, alimenté sous les mêmes potentiels Vdd et Vss et fonctionnant à la même température,
- l'impédance équivalente au pont résistif doit être égale à l'impédance caractéristique Zc de la ligne 13, typiquement de 50 ohms,
- l'excursion de tension sur la ligne de transmission doit être fixe et déterminée dans l'exemple choisi de façon à assurer la compatibilité ECL qui est typiquement de 0,8 volt, et
- l'excursion de tension sur la ligne doit être symétrique autour du seuil Vtt.

La structure du pont résistif 17 avec deux transistors complémentaires N1 et P1 montés en série entre les potentiels d'alimentation Vdd et Vss peut être faite selon les trois variantes représentées sur les figures 7A, 7B et 7C. Les deux transistors N1 et P1 sont tous deux conducteurs pour travailler en mode résistif. Il existe deux types de montage selon que le transistor P1 est connecté au potentiel Vdd comme illustré dans les figures 7A et 7B, ou que c'est le transistor N1 comme dans la figure 7C. Pour chacun de ces deux types de montage, la connexion de la grille du transistor N1 au potentiel Vdd et de la grille du transistor P1 au potentiel Vss donne les deux variantes illustrées dans les figures 7A et 7C. Dans la figure 7A, Vgs = Vdd et dans la figure 7C, Vgs = Vds. Dans la figure 7B, les grilles sont connectées aux drains des deux transistors, de sorte que Vgs = Vds.

La figure 8 est un graphe illustrant les caractéristiques statiques d'un transistor MOS monté de façon que Vgs = Vdd (courbe en trait continu fin) ou que Vgs = Vds (courbe en trait continu gras). L'axe des abscisses représente les variations de la tension Vds allant de zéro volt au potentiel Vdd, tandis que l'axe des ordonnées représente l'intensité I du courant drain-source. Il apparaît que le montage à Vgs = Vds est plus sensible aux dispersions du potentiel de seuil Vtt du transistor mais il nécessite, pour la même impédance dynamique, un courant de polarisation beaucoup plus faible. Comme dans l'exemple illustré les caractéristiques des ensembles de transistors sont déterminées par des boucles d'asservissement prenant en compte les variations du potentiel de seuil Vtt des transistors de circuits intégrés différents, le montage à Vgs = Vds a été choisi afin de minimiser la consommation électrique statique. Il reste donc à choisir entre les deux montages des figures 7B et 7C, où Vgs = Vds. Compte tenu de l'exemple choisi de sélectionner les transistors actifs en parallèle dans chaque ensemble en activant leurs grilles, le montage de la figure 7C offre l'avantage d'avoir les drains à un potentiel fixe et de faciliter ainsi la commande des grilles. Le pont résistif 17 du récepteur 12 illustré dans la figure 4 et les ponts résistifs 17' du bloc d'adaptation d'impédance 15 dans la figure 2 utilisent donc le montage de la figure 7C. Avantageusement, l'un des seize transistors N1 et l'un des seize transistors P1 est un transistor talon rendus toujours passant, de sorte que l'activation sélective concerne les quinze autres transistors. Ces quinze transistors ne sont pas identiques, mais sont taillés de telle sorte que l'addition d'un transistor sélectionné augmente la taille totale des transistors actifs d'un pourcentage constant. Les transistors rendus actifs sont donc de plus en plus gros. En d'autres termes, les résistances que forment les groupes de transistors N1 et P1 sont dimensionnées de façon que leurs activations successives conduisent à des valeurs régulièrement décroissantes de la résistance équivalente de ces groupes. En contrepartie, ceci entraîne, pour une précision donnée, une'augmentation du nombre de résistances et donc de signaux de commande. Pour compenser cet inconvénient, on utilise un signal de commande codé.

Pour la réalisation des boucles d'asservissement, le critère le plus difficile à satisfaire est de rendre l'impédance équivalente du pont résistif 17 constamment égale à l'impédance caractéristique Zc de la ligne 13. A cause de la dérive technologique des éléments contenus dans des circuits intégrés différents, l'ajustement des résistances N1 et P1 est fait en référence à une résistance étalon ayant la valeur désirée et non intégrée dans le circuit IC. Pour faire la comparaison de la résistance d'entrée du récepteur 12 avec la résistance de référence Rr, il a été choisi dans l'exemple illustré dans la figure 2 d'utiliser la structure 16 de l'étage de sortie Ne, Pe de l'émetteur 11, en la reproduisant en la structure 16' faite des mêmes transistors N'e et P'e et en la dimensionnant de façon à produire une excursion de tension définie dans la résistance de référence Rr, puis en utilisant l'étage de sortie 16 pour produire un courant identique à celui de l'étage de sortie 16' et y obtenir la même excursion de tension. Les deux étages de sortie identiques 16' et 16 produisent donc des potentiels identiques, le premier dans la résistance de référence Rr et le second dans le pont résistif 17. Cela assure que le pont résistif a une résistance équivalente égale à la résistance de référence.

Le problème est plus compliqué, du fait que l'excursion de tension n'est pas, dans les conditions de l'exemple illustré, une tension prédéfinie ou se référant à un potentiel d'alimentation, mais qu'elle est centrée autour d'un potentiel de seuil Vtt qui n'est pas prédéfini et qui dépend du procédé de fabrication, de la tension d'alimentation et de la température. Pour résoudre ce problème, on utilise le circuit schématique de principe illustré dans la figure 9 et basé sur le fait que le pont résistif 17 est équivalent à la résistance caractéristique Zc connectée à une source de potentiel égal à Vtt et que l'excursion de tension du signal de sortie d'émission Ve-out est définie par son potentiel bas Vl et son potentiel haut Vh.

Dans la figure 9, les deux transistors Ne et Pe sont considérés comme fournissant un courant équivalent aux groupes des transistors Ne et Pe de l'étage de sortie 16 de l'émetteur. Le transistor Ne a sa source au potentiel d'alimentation Vss et son drain au potentiel bas Vl, tandis que le transistor Pe a sa source au potentiel Vdd et son drain au potentiel haut Vh. Le transistor Pe génère dans la résistance Zc connectée au potentiel de seuil Vtt d'entrée du récepteur 12 une excursion de tension Vh - Vtt égale à la moitié de l'excursion totale Vh - Vl, tandis que le transistor Ne génère l'excursion égale et opposée, Vtt - Vl. L'étage de sortie 16 de l'émetteur 11 peut être ainsi considéré comme un groupe de transistors Ne et un ensemble de transistors Pe interconnectés par une résistance de référence Rr valant 2Zc et commandés chacun de façon à avoir aux deux extrémités de la résistance de référence Rr deux potentiels bas Vl et haut Vh centrés autour de la tension de seuil Vtt et déterminés par l'excursion de tension désirée. La structure 16' du bloc d'adaptation d'impédance 14 est donc la copie de référence désirée de l'étage de sortie 16 de l'émetteur 11. Les conditions déterminant cette copie de référence sont recopiées dans l'émetteur 11 par les boucles d'asservissement Len et Lep pour être parfaitement adapté à la ligne de transmission 13 et y produire les potentiels désirés.

Les quatre boucles d'asservissement peuvent être analogiques ou numériques. Elles ont été choisies totalement numériques afin d'être résistantes aux bruits et facilement portables par des procédés de fabrication différents. Dans l'exemple illustré, les circuits de sélection 19n, 19p et 25n, 25p sont faits chacun d'un compteur-décompteur. Un séquenceur génère des signaux d'horloge pour commander alternativement les quatre boucles. Les signaux d'horloge commandent les compteurs-décompteurs en fonction du résultat fourni par les comparateurs 18n, 18p et 24n, 24p. Les comparateurs sont constitués de préférence par des inverseurs CMOS, dont le seuil de commutation est déterminé par le dimensionnement respectif des deux transistors complémentaires qui composent ces inverseurs.

Dans l'exemple illustré, les deux potentiels de référence choisis sont le potentiel de seuil Vtt et le niveau bas Vl de l'excursion. Le niveau haut Vh est défini par symétrie par rapport à Vtt. De plus, les comparateurs relatifs aux deux potentiels de référence Vl et Vtt ont été choisis de deux types différents. Les comparateurs 18n et 24n relatifs à Vtt sont chacun fait d'un inverseur centré, identique à l'amplificateur Nr, Pr du récepteur 12 dont le seuil est Vtt, et les comparateurs relatifs à Vl sont chacun faits d'un inverseur décentré pour que son seuil de commutation soit inférieur à Vtt de 0,4 volt, puisque l'amplitude crête à crête a été choisie égale à 0,8 volt.

Dans la structure choisie dans l'exemple illustré, les deux inverseurs 18n, 18p et 24n, 24p, les transistors Ne, Pe constitutifs de l'étage de sortie 16 de l'émetteur 11 et les transistors N1, P1 du pont résistif 17 du récepteur sont les seuls éléments à comportement linéaire de tout l'ensemble incorporé dans le circuit intégré IC représenté sur la figure 1 et formé par le dispositif d'adaptation d'impédance 10, les émetteurs 11 et les récepteurs 12. Pour changer de technologie, il suffit donc d'ajuster, en fonction des caractéristiques du procédé de fabrication du circuit intégré IC, le dimensionnement relatif des transistors CMOS constitutifs des deux inverseurs et le dimensionnement "absolu" des transistors de l'émetteur et du récepteur pour qu'ils fournissent les impédances désirées. Le reste des éléments utilisés sont purement numériques et sont très peu sensibles aux changements technologiques de fabrication.

Le fonctionnement des deux boucles d'asservissement d'émetteur Len et Lep ressort maintenant bien en référence aux figures 2 et 3. Dans le bloc 14 les deux boucles règlent les groupes respectifs des transistors N'e et P'e en les faisant débiter dans la résistance de référence Rr égale à 2Zc. Le groupe de transistors N'e est commandé par le compteur-décompteur 19n en réponse au signal de sortie du comparateur 18n. Si le potentiel au point A est supérieur au niveau bas Vl, le nombre de transistors actifs N'e est augmenté de façon à rendre le groupe moins résistif et à ramener ainsi le potentiel au point A à la valeur Vl. Inversement, on diminue le nombre de transistors actifs N'e si le potentiel au point A est inférieur à V1 pour l'ajuster à cette valeur. Le groupe de transistors P'e est commandé par le compteur-décompteur 19p en réponse au signal de sortie du comparateur 18p. Si le potentiel au point C est supérieur à Vtt, on diminue le nombre des transistors actifs dans le groupe de façon à le rendre plus résistif et à ramener ainsi le potentiel au point C à la valeur Vtt, et inversement. Les deux boucles réagissent l'une sur l'autre. Elles sont donc avantageusement activées séquentiellement, par exemple un top d'horloge pour l'une, puis un top d'horloge pour l'autre, et ainsi de suite jusqu'à compter seize tops pour chaque boucle. Les deux boucles vont tendre vers le nombre recherché de transistors actifs N'e et P'e dans les groupes respectifs. Lorsque ce nombre est atteint, le contenu des compteurs-décompteurs 19n et 19p varie à chaque top d'horloge de +1 ou -1 autour de la valeur recherchée. A la fin des seize tops, la moyenne des seize valeurs contenues dans les compteurs-décompteurs 19n et 19p est calculée dans les codeurs 20n et 20p. Cette valeur moyenne est considérée comme la valeur recherchée pour le nombre de transistors N'e et P'e actifs dans les groupes respectifs. Cette valeur est codée avant d'être transmise comme signal d'ajustement n-em, p-em, afin de ne pas transmettre ces signaux d'une façon linéaire qui obligerait de distribuer un grand nombre de bits dans le circuit intégré IC. Le code Gray a été choisi pour qu'un seul bit change à la fois. Ainsi on ne risque pas, lors d'un ajustement de la valeur de l'impédance caractéristique, de passer par une valeur intermédiaire très différente de la valeur souhaitée. Dans l'émetteur 11, l'étage de sortie 16 est commandé par les signaux n-em et p-em de façon à produire le courant d'émission dans les conditions désirées d'adaptation d'impédance.

Le fonctionnement des deux boucles d'asservissement de récepteur Lrn et Lrp va maintenant être décrit en référence aux figures 2 et 4. Les valeurs moyennes émises par les signaux codés d'ajustement n-em et p-em sont décodés et recopiées dans les deux groupes de transistors N"e et P"e identiques aux deux groupes d'émission N'e et P'e et qui serviront à commander les boucles de réception. Les deux groupes de transistors N"e et P"e commandent indépendamment les deux ponts résistifs 17', et les commandent simultanément de façon que les deux ponts soient identiques à tout moment. Le groupe de transistors N"e doit tirer le potentiel au point A jusqu'au niveau bas Vl de la transmission désirée. Il est donc commandé par le compteur-décompteur 25n, lui-même commandé par l'inverseur 24n. Le principe est semblable à celui des boucles d'émission. D'autre part, le groupe de transistors P"e doit tirer le potentiel au point B jusqu'au niveau haut Vh de la transmission désirée. Il est donc commandé ici par le compteur-décompteur 25p, lui-même commandé par la sortie de l'inverseur 24p. Cet inverseur compare, relativement à Vtt, le potentiel moyen entre les points intermédiaires des deux ponts 17', l'un tiré vers le haut par les transistors N"e et l'autre tiré vers le bas par les transistors P"e. A l'évidence, les deux boucles Lrn et Lrp réagissent l'une sur l'autre. Un séquencement identique à celui des boucles d'émission est donc utilisé pour calculer la valeur moyenne des seize contenus des deux compteurs-décompteurs 25n et 25p et les envoyer sous forme de signaux codés de commande n-rec et p-rec aux récepteurs 12 du circuit intégré IC. Dans ces récepteurs, les signaux de commande sont décodés pour ajuster le nombre des transistors N1 et P1 aux valeurs moyennes respectives déterminées par les codeurs 26n et 26p. En conclusion, la solution de principe apportée par l'invention consiste à intégrer la résistance d'adaptation sous la forme du pont résistif 17 et à l'asservir pour qu'elle ait la valeur désirée.

De nombreuses variantes peuvent être apportées à l'exemple décrit et illustré. Il ressort ainsi que la structure désirée peut être différente de celle choisie à titre d'exemple. D'autres technologies que la technologie CMOS sont tout à fait possibles. On a vu que des amplificateurs symétriques pouvaient être utilisés dans une autre technologie que CMOS ou dans la technologie CMOS si une large bande passante n'est pas requise. Dans ce cas, le récepteur ne nécessiterait pas de potentiel de polarisation. Même dans l'exemple illustré, la consommation statique pourrait provenir de l'extérieur du circuit intégré, par exemple en y ajoutant une borne d'alimentation pour fournir le potentiel Vtt.

En résumé, conformément au procédé d'adaptation d'impédance qui vient d'être décrit et de ses diverses variantes, il suffit d'abord de déterminer la structure désirée d'émetteur et/ou de récepteur, par exemple le type de structure et sa technologie de fabrication, ainsi que les conditions désirées de son fonctionnement.On reproduit ensuite la structure désirée pour en faire une structure d'adaptation, telle qu'elle existe dans les blocs 14 et 15 de l'exemple illustré. On connecte alors la structure d'adaptation à une résistance de référence Rr dont la valeur assure, dans les conditions de fonctionnement désirées, une adaptation d'impédance de la structure d'adaptation. Il suffit alors d'asservir le fonctionnement de la structure désirée sur celui de la structure d'adaptation.

Dans l'exemple illustré, le type de la structure désirée est celui représenté sur la figure 6 et les conditions désirées comprennent les valeurs désirées des niveaux haut et bas des signaux émis et/ou reçus. Cependant, on a vu que ces conditions étaient requises pour assurer la compatibilité avec la technologie ECL et qu'elles sont donc optionnelles.

Dans l'exemple illustré, on a vu que pour l'obtention des valeurs désirées des niveaux haut et bas, le procédé consiste à prendre l'une (VI) de ces deux valeurs et à déterminer l'autre valeur Vh par rapport à une troisième valeur désirée de tension comprise entre les deux niveaux haut et bas et déterminée par la valeur du potentiel de polarisation (Vtt) dans la structure désirée. Cependant, on pourrait tout aussi bien déterminer la valeur de Vtt à partir des deux niveaux Vl et Vh. Dans ce cas, la résistance intermédiaire Ri pourrait être supprimée dans la structure d'adaptation 16'.

Dans l'exemple illustré, la structure désirée 16 est faite sur la base d'un inverseur de type CMOS (Ne, Pe) dans l'émetteur. Cette technologie utilise un type particulier des transistors à effet de champ, mais tout autre type pourrait aussi s'appliquer. Dans le cas particulier de la structure choisie et fonctionnant dans les conditions qui viennent d'être données, on a vu que le procédé de l'invention consiste à connecter dans la structure d'adaptation 16' l'impédance de référence Rr en série entre les transistors complémentaires de l'inverseur et à donner à l'impédance de référence la valeur double de celle de l'impédance caractéristique de la ligne. Dans l'exemple illustré, l'impédance de référence Rr n'est pas incorporée dans le matériau semi-conducteur du circuit intégré IC du fait des très grandes dispersions technologiques dans la technologie CMOS. Cependant, d'une manière générale, elle pourrait être incorporée ou attachée au réseau d'interconnexion métallique du circuit intégré, de manière fixe au ajustable par divers moyens connus, par laser par exemple. La résistance de référence pourrait aussi être incorporée dans le matériau semi-conducteur du circuit intégré, par exemple sous forme d'un groupe de transistors à effet de champ en parallèle, dûment sélectionnés pour correspondre à la valeur désirée. La solution présentée dans le document EP-A-0504062 consiste à asservir des impédances, dans l'émetteur ou le récepteur haute fréquence d'un circuit intégré, sur une valeur d'impédance extérieure au circuit intégré, afin de reproduire cette valeur d'impédance dans le circuit intégré pour servir de valeur de référence et d'asservir les autres impédances sur cette valeur de référence. Mais cette solution ne peut compenser une dérive des caractéristiques par vieillissement du circuit intégré ou par un changement de température qu'en faisant une nouvelle adaptation sur la résistance extérieure. Plus généralement, cette solution convient bien dans un contexte nettement moins contraignant que celui qui vient d'être exposé. Quant à la valeur de l'impédance de référence, la description qui précède a bien mis en relief qu'elle vaut 2Zc dans le cas particulier de la structure et du fonctionnement choisis, tels qu'illustrés dans la figure 9. En d'autres termes, elle pourrait avoir d'autres valeurs selon la structure et le fonctionnement choisis.

Dans l'exemple illustré dans la figure 6, la structure désirée comprend aussi un pont résistif 17 dans le récepteur 12 pour déterminer le potentiel de polarisation désiré Vtt. On a vu dans ce cas que le procédé de l'invention consiste à reproduire le pont résistif en deux ponts d'adaptation 17', à les faire fonctionner dans les conditions désirées d'émission et de réception assurant l'adaptation d'impédance, et asservir les valeurs des résistances du pont résistif du récepteur sur celles de la structure d'adaptation.

Il s'ensuit que l'invention a aussi pour objet un dispositif d'adaptation d'impédance 10 à l'impédance caractéristique Zc d'une ligne de transmission 13 entre un émetteur 11 et un récepteur 12, comprenant dans l'émetteur et/ou le récepteur une structure 16, 17 désirée fonctionnant dans des conditions désirées. Selon l'invention, le dispositif comprend une structure d'adaptation 16', 17' reproduisant la structure désirée et connectée à une impédance de référence assurant, dans les conditions de fonctionnement désirées, l'adaptation d'impédance, et un dispositif d'asservissement de la structure désirée à la structure adaptée.

Dans l'exemple décrit, la structure désirée comprend un inverseur 16 de type CMOS dans l'émetteur 11 et, dans le récepteur 12, un inverseur Nr, Pr de type CMOS polarisé par un pont résistif d'entrée 17, et en ce que dans la structure d'adaptation 16' l'impédance de référence Rr vaut deux fois l'impédance caractéristique de la ligne.

D'autre part, le pont résistif est fait de deux types complémentaires de transistors N1, P1 en série entre deux potentiels d'alimentation, montés de façon que Vgs = Vds et que leurs connexions avec les potentiels d'alimentation soient inverses de celles des transistors d'un inverseur de type CMOS. On a vu à cette occasion que d'autres types de ponts résistifs étaient possibles dans le cadre de circuits utilisant les transistors à effet de champ.

On a vu aussi que le dispositif d'asservissement choisi est de type numérique, mais qu'il pouvait être aussi analogique. Dans l'exemple illustré, l'asservissement est continu et se fait sur des valeurs moyennes pour éviter une oscillation des valeurs d'asservissement autour de valeurs moyennes. Plus généralement, l'asservissement pourrait être discontinu, fait seulement pendant des moments cycliques, ou seulement lors de l'initialisation du fonctionnement du circuit intégré, si les conditions d'utilisation sont relativement stables. Les codeurs pourraient être alors des éléments de mémoire. Quant aux codeurs-décodeurs, ils sont avantageux mais optionnels quant à leur emploi et à leur type.

Il en résulte que l'invention a aussi pour objet un circuit intégré IC, comprenant un émetteur et/ou un récepteur destinés à être reliés par au moins une ligne de transmission 13 et adaptés sur l'impédance caractéristique de la ligne conformément au procédé qui vient d'être défini ou incorporant un dispositif d'adaptation d'impédance qui a été défini. Plus précisément, il ressort de 1' exemple illustré que l'invention pourrait s'appliquer à un circuit intégré IC n'incorporant que des émetteurs ou que des récepteurs. Dans le premier cas, il ne comprendrait que les émetteurs 11 et le bloc 14 connecté à la résistance de référence Rr. Dans le second cas, il pourrait n'incorporer que les récepteurs 12 et le bloc 15 dans lequel la structure d'adaptation de réception 16" serait identique à la structure d'adaptation d'émission 16' et connectée à la résistance de référence Rr. Cet exemple montre aussi que les conditions de fonctionnement désirées des récepteurs impliquent un fonctionnement désiré des émetteurs. L'invention peut donc être remarquable dans les systèmes de transmission entre plusieurs circuits intégrés mettant en oeuvre le procédé de l'invention, puisque le procédé d'adaptation d'impédance implique l'utilisation des structures désirées d'émission et de réception.

L'invention a donc aussi pour objet un système de transmission SYS tel que par exemple représenté sur la figure 10, comprenant des circuits intégrés IC1, IC2, IC3, ... incorporant chacun des émetteurs et/ou des récepteurs et reliés entre eux par des lignes de transmission 13, les circuits intégrés étant du type qui vient d'être défini.

## Revendications

1. Procédé d'adaptation d'impédance sur l'impédance caractéristique (Zc) d'une ligne (13) de transmission d'un signal entre un émetteur (11) et un récepteur (12), le procédé consistant à utiliser un pont résistif (17) formé de deux résistances ajustables (N1, P1) en série entre deux potentiels d'alimentation (Vdd, Vss) et dont le point commun est connecté à l'entrée du récepteur (12), à reproduire dans un bloc d'adaptation (15) du récepteur (12) le pont résistif (17) en deux ponts résistifs constituant une structure d'adaptation (17'), à connecter les deux ponts résistifs de la structure d'adaptation (17') aux deux extrémités respectives d'une impédance de référence (Rr) et à effectuer dans le bloc d'adaptation (15) du récepteur (12) un asservissement (Lrn, Lrp, 24n, 24p, 25n, 25p) se référant à deux valeurs données de potentiels du signal de transmission et commandant les deux résistances respectives (N1, P1, N'1, P'1) des ponts résistifs (17, 17') du récepteur (12) et de la structure d'adaptation (15) correspondante.

2. Procédé selon la revendication 1, selon lequel le pont résistif (17) détermine un potentiel de polarisation (Vtt) du récepteur.

3. Procédé selon la revendication 2, selon lequel les résistances ajustables du pont résistif (17) sont respectivement faites de deux types complémentaires de transistors (N1, P1) en série entre les deux potentiels d'alimentation (Vdd, Vss), chaque transistor ayant une tension grille-source (Vgs) égale à la tension drain-source (Vds) et leurs connexions avec les potentiels d'alimentation étant inverses de celles des transistors d'un inverseur de type CMOS.

4. Procédé selon l'une des revendications 1 à 3, consistant en outre à faire correspondre les deux valeurs données de potentiels aux niveaux haut et bas (Vh, Vl) dudit signal de transmission.

5. Procédé selon la revendication 4, consistant en outre, pour l'obtention des valeurs données des niveaux haut et bas, à prendre l'une (Vl) de ces valeurs et à déterminer l'autre valeur (Vh) par rapport à une troisième valeur donnée de tension comprise entre les deux niveaux haut et bas et déterminée par la valeur du potentiel de polarisation (Vtt) du récepteur.

6. Procédé selon l'une des revendications 1 à 5, consistant en outre à connecter dans un bloc d'adaptation (14) de l'émetteur (11) l'impédance de référence (Rr) à une structure d'adaptation (16') d'émetteur reproduisant la structure (16) de l'émetteur (11).

7. Procédé selon la revendication 6, selon lequel la structure (16) de l'émetteur (11) incluant un inverseur CMOS (Ne, Pe) ayant des transistors complémentaires, l'impédance de référence (Rr) est connectée en série entre les transistors complémentaires d'un inverseur (N'e, P'e) constituant la structure d'adaptation (16') du bloc d'adaptation (14) de l'émetteur.

8. Procédé selon l'une des revendications 1 à 7, consistant à donner à l'impédance de référence (Rr) la valeur double de celle de l'impédance caractéristique de la ligne.

9. Procédé selon l'une des revendications 1 à 8, consistant à reproduire la structure (16) de l'émetteur (11) incluant un inverseur CMOS (Ne, Pe) en une structure d'adaptation (16') dans un bloc d'adaptation (14) de l'émetteur, à connecter cette structure d'adaptation (16') à l'impédance de référence (Rr) et à effectuer un asservissement (Len, Lep, 18n, 18p, 19n, 19p) se référant aux deux valeurs données de potentiels du signal de transmission et commandant les deux resistances respectives (Ne, Pe, N'e, P'e) des inverseurs (16, 16') de l'émetteur (11) et de la structure d'adaptation (16) correspondante.

10. Procédé selon l'une des revendications 1 à 9, selon lequel l'asservissement est numérique.

11. Procédé selon l'une des revendications précédentes, selon lequel le récepteur est un inverseur (Nr, Pr) de type CMOS polarisé par le pont résistif (17).

12. Procédé d'adaptation parallèle d'impédance sur l'impédance caractéristique (Zc) d'une ligne (13) de transmission d'un signal entre un émetteur (11), qui inclut une structure d'inverseur CMOS (16) fait de deux transistors complémentaires (Ne, Pe) en série, et un récepteur (12), le procédé consistant à reproduire, dans un bloc d'adaptation (14) de l'émetteur (11), l'inverseur (16) en une structure d'adaptation (16'), à connecter une impédance de référence (Rr) en série entre les deux transistors complémentaires (N'e, P'e) de la structure d'adaptation (16') et à effectuer un asservissement (Len, Lep, 18n, 18p, 19n, 19p) se référant aux deux valeurs données de potentiels du signal de transmission et commandant les deux résistances respectives (Ne, Pe, N'e, P'e) des inverseurs (16, 16') de l'émetteur (11) et de la structure d'adaptation (16) correspondante.

13. Procédé selon la revendication 12, consistant à donner à l'impédance de référence (Rr) la valeur double de celle de l'impédance caractéristique de la ligne.

14. Procédé selon la revendication 12 ou 13, consistant à faire correspondre les valeurs données de potentiels des niveaux haut et bas (Vh, Vl) dudit signal de transmission et à faire l'asservissement sur les valeurs déterminées en des points correspondants (A, B, C) de la structure d'adaptation.

15. Circuit intégré (IC) mettant en oeuvre le procédé tel que défini par l'une des revendications précédentes, comprenant un émetteur (11) et/ou un récepteur (12) destinés respectivement à être reliés par au moins une ligne de transmission (13) à un récepteur et/ou à un émetteur correspondant, le récepteur comprenant un pont résistif (17) formé de deux résistances ajustables (N1, P1) en série entre deux potentiels d'alimentation (Vdd, Vss) et dont le point commun est connecté à l'entrée du récepteur (12), un bloc d'adaptation (15) reproduisant le pont résistif (17) en deux ponts résistifs constituant une structure d'adaptation (17'), les deux ponts résistifs de la structure d'adaptation (17') étant connectés aux deux extrémités respectives d'une impédance de référence (Rr), un dispositif d'asservissement (Lrn, Lrp, 24n, 24p, 25n, 25p), pour effectuer dans le bloc d'adaptation (15) du récepteur (12) un asservissement (Lrn, Lrp, 24n, 24p, 25n, 25p) se référant à deux valeurs données de potentiels du signal de transmission et pour commander les deux résistances respectives (N1, P1, N'1, P'1) des ponts résistifs (17, 17') du récepteur (12) et de la structure d'adaptation (15) correspondante et l'émetteur comprenant une structure d'inverseur CMOS (16) fait de deux transistors complémentaires (Ne, Pe) en série, un bloc d'adaptation (14) reproduisant l'inverseur (16) en une structure d'adaptation (16'), une impédance de référence (Rr) en série connectée entre les deux transistors complémentaires (N'e, P'e) de la structure d'adaptation (16') et un dispositif d'asservissement (Len, Lep, 18n, 18p, 19n, 19p) pour effectuer dans le bloc d'adaptation (14) de l'émetteur (11) un asservissement (Len, Lep, 18n, 18p, 19n, 19p) se référant à deux valeurs données de potentiels du signal de transmission et pour commander les deux résistances respectives (Ne, Pe, N'e, P'e) des inverseurs (16, 16') de l'émetteur (11) et de la structure d'adaptation (16) correspondante.

16. Système de transmission (SYS) comprenant des circuits intégrés (ICI, IC2, IC3) incorporant des émetteurs et/ou des récepteurs et reliés entre eux par des lignes de transmission (13), le système incorporant des circuits intégrés du type défini par la revendication 15.

## Patentansprüche

1. Verfahren zum Anpassen der Impedanz an die charakteristische Impedanz (Zc) einer Signalübertragungsleitung (13) zwischen einem Sender (11) und einem Empfänger (12), wobei das Verfahren darin besteht, eine Widerstandsbrücke (17) zu verwenden, die aus zwei einstellbaren Widerständen (N1, P1) gebildet ist, die zwischen zwei Versorgungspotentialen (Vdd, Vss) in Reihe geschaltet sind und deren gemeinsamer Punkt an den Eingang des Empfängers (12) angeschlossen ist, in einem Anpassungsblock (15) des Empfängers (12) die Widerstandsbrücke (17) in zwei Widerstandsbrücken nachzubilden, die eine Anpassungsstruktur (17') bilden, die beiden Widerstandsbrücken der Anpassungsstruktur (17') an die beiden jeweiligen Enden einer Referenzimpedanz (Rr) anzuschließen und in dem Anpassungsblock (15) des Empfängers (12) eine Regelung (Lrn, Lrp, 24n, 24p, 25n, 25p) auszuführen, indem auf zwei gegebene Potentialwerte des Übertragungssignals Bezug genommen wird und indem die beiden jeweiligen Widerstände (N1, P1, N'1, P'1) der Widerstandsbrücken (17, 17') des Empfängers (12) und der entsprechenden Anpassungsstruktur (15) gesteuert werden.

2. Verfahren nach Anspruch 1, bei dem die Widerstandsbrücke (17) ein Vorspannungspotential (Vtt) des Empfängers bestimmt.

3. Verfahren nach Anspruch 2, bei dem die einstellbaren Widerstände der Widerstandsbrücke (17) jeweils aus zwei komplementären Typen von Transistoren (N1, P1) gebildet sind, die zwischen die beiden Versorgungspotentiale (Vdd, Vss) in Reihe geschaltet sind, wobei jeder Transistor eine Gate-Source-Spannung (Vgs) besitzt, die gleich der Drain-Source-Spannung (Vds) ist, und wobei ihre Verbindungen mit den Versorgungspotentialen zu jenen der Transistoren eines-Inverters des CMOS-Typs entgegengesetzt sind

4. Verfahren nach einem der Ansprüche 1 bis 3, das außerdem darin besteht, eine Entsprechung zwischen den beiden gegebenen Potentialwerten und den hohen und tiefen Pegeln (Vh, Vl) des Übertragungssignals herzustellen.

5. Verfahren nach Anspruch 4, das außerdem für den Erhalt der gegebenen Werte mit hohen und tiefen Pegeln darin besteht, einen (Vl) dieser Werte zu verwenden und den anderen Wert (Vh) in bezug auf einen dritten gegebenen Spannungswert, der zwischen dem hohen bzw. dem tiefen Pegel liegt und durch den Wert des Vorspannungspotentials (Vtt) des Empfängers bestimmt ist, zu bestimmen.

6. Verfahren nach einem der Ansprüche 1 bis 5, das außerdem darin besteht, in einem Anpassungsblock (14) des Senders (11) die Referenzimpedanz (Rr) an eine Anpassungsstruktur (16') des Senders, die die Struktur (16) des Senders (11) nachbildet, anzuschließen.

7. Verfahren nach Anspruch 6, bei dem die Struktur (16) des Senders (11) einen CMOS-Inverter (Ne, Pe) enthält, der komplementäre Transistoren besitzt, wobei die Referenzimpedanz (Rr) zwischen die komplementären Transistoren eines Inverters (N'e, P'e), der die Anpassungsstruktur (16') des Anpassungsblocks (14) des Senders bildet, in Reihe geschaltet ist.

8. Verfahren nach einem der Ansprüche 1 bis 7, das darin besteht, der Referenzimpedanz (Rr) den doppelten Wert der charakteristischen Impedanz der Leitung zu verleihen.

9. Verfahren nach einem der Ansprüche 1 bis 8, das darin besteht, die Struktur (16) des Senders (11), der einen CMOS-Inverter (Ne, Pe) enthält, in einer Anpassungsstruktur (16') in einem Anpassungsblock (14) des Senders nachzubilden, diese Anpassungsstruktur (16') an die Referenzimpedanz (Rr) anzuschließen und eine Regelung (Len, Lep, 18n, 18p, 19n, 19p) auszuführen, indem auf die beiden gegebenen Potentialwerte des Übertragungssignals Bezug genommen wird, und indem die beiden jeweiligen Widerstände (Ne, Pe, N'e, P'e) der Inverter (16, 16') des Senders (11) bzw. der entsprechenden Anpassungsstruktur (16) gesteuert werden.

10. Verfahren nach einem der Ansprüche 1 bis 9, bei dem die Regelung digital ist.

11. Verfahren nach einem der vorhergehenden Ansprüche, bei dem der Empfänger ein Inverter (Nr, Pr) des CMOS-Typs ist, der durch die Widerstandsbrücke (17) vorgespannt ist.

12. Verfahren zur parallelen Impedanzanpassung an die charakteristische Impedanz (Zc) einer Übertragungsleitung (13) eines Signals zwischen einem Sender (11), der eine CMOS-Inverterstruktur (16) enthält und aus zwei in Reihe geschalteten komplementären Transistoren (Ne, Pe) gebildet ist, und einem Empfänger (12), wobei das Verfahren darin besteht, in einem Anpassungsblock (14) des Senders (11) den Inverter (16) in einer Anpassungsstruktur (16') nachzubilden, eine Referenzimpedanz (Rr) zwischen den beiden komplementären Transistoren (N'e, P'e) der Anpassungsstruktur (16') in Reihe zu schalten und eine Regelung (Len, Lep, 18n, 18p, 19n, 19p) auszuführen, indem auf die beiden gegebenen Potentialwerte des Übertragungssignals Bezug genommen wird und indem die beiden jeweiligen Widerstände (Ne, Pe, N'e, P'e) der Inverter (16, 16') des Senders (11) bzw. der entsprechenden Anpassungsstruktur (16) gesteuert werden.

13. Verfahren nach Anspruch 12, das darin besteht, der Referenzimpedanz (Rr) den doppelten Wert der charakteristischen Impedanz der Leitung zu verleihen.

14. Verfahren nach Anspruch 12 oder 13, das darin besteht, eine Entsprechung zwischen den gegebenen Potentialwerten und den hohen und tiefen Pegeln (Vh, Vl) des Übertragungssignals herzustellen und die Regelung an den bestimmten Werten an entsprechenden Punkten (A, B, C) der Anpassungsstruktur auszuführen.

15. Integrierte Schaltung (IC), die das Verfahren, das in einem der vorhergehenden Ansprüche definiert ist, ausführt und versehen ist mit einem Sender (11) und/oder einem Empfänger (12), die jeweils dazu vorgesehen sind, über wenigstens eine Übertragungsleitung (13) mit einem entsprechenden Empfänger und/oder Sender verbunden zu werden, wobei der Empfänger eine Widerstandsbrücke (17), die aus zwei einstellbaren Widerständen (N1, P1) gebildet ist, die zwischen zwei Versorgungspotentiale (Vdd, Vss) in Reihe geschaltet sind und deren gemeinsamer Punkt an den Eingang des Empfängers (12) angeschlossen ist, einen Anpassungsblock (15), der die Widerstandsbrücke (17) in zwei Widerstandsbrücken nachbildet, die eine Anpassungsstruktur (17') bilden, wobei die beiden Widerstandsbrücken der Anpassungsstruktur (17') an die beiden jeweiligen Enden einer Referenzimpedanz (Rr) angeschlossen ist, eine Regelungsvorrichtung (Lrn, Lrp, 24n, 24p, 25n, 25p) zum Ausführen einer Regelung (Lrn, Lrp, 24n, 24p, 25n, 25p) im Anpassungsblock (15) des Empfängers (12) unter Bezugnahme auf zwei gegebene Potentialwerte des Übertragungssignals und zum Steuern der beiden jeweiligen Widerstände (N1, P1, N'1, P'1) der Widerstandsbrücken (17, 17') des Empfängers (12) bzw. der entsprechenden Anpassungsstruktur (15) umfaßt und wobei der Sender eine CMOS-Inverterstruktur (16), die aus zwei in Reihe geschalteten komplementären Transistoren (Ne, Pe) gebildet ist, einen Anpassungsblock (14), der den Inverter (16) in einer Anpassungsstruktur (16') nachbildet, eine Referenzimpedanz (Rr), die zwischen die beiden komplementären Transistoren (N'e, P'e) der Anpassungsstruktur (16') in Reihe geschaltet ist, sowie eine Regelungsvorrichtung (Len, Lep, 18n, 18p, 19n, 19p) zum Ausführen einer Regelung (Len, Lep, 18n, 18p, 19n, 19p) im Anpassungsblock (14) des Senders (11) unter Bezugnahme auf zwei gegebene Potentialwerte des Übertragungssignals und zum Steuern der beiden entsprechenden Widerstände (Ne, Pe, N'e, P'e) der Inverter (16, 16') des Senders (11) bzw. der entsprechenden Anpassungsstruktur (16) umfaßt.

16. Übertragungssystem (SYS) mit integrierten Schaltungen (IC1, IC2, IC3), die Sender und/oder Empfänger enthalten und miteinander über Übertragungsleitungen (13) verbunden sind, wobei das System integrierte Schaltungen des durch Anspruch 15 definierten Typs umfaßt.

## Claims

1. Method for matching impedance to the characteristic impedance (Zc) of a line (13) for transmitting a signal between a transmitter (11) and a receiver (12), the method consisting in using a resistance bridge (17) formed of two adjustable resistors (N1, P1) in series between two supply potentials (Vdd, Vss) and in which the common point is connected to the input of the receiver (12), in reproducing within a matching unit (15) of the receiver (12) the resistance bridge (17) as two resistance bridges constituting a matching structure (17'), in connecting the two resistance bridges of the matching structure (17') to the two respective ends of a reference impedance (Rr) and in creating, within the matching unit (15) of the receiver (12) a closed-loop control (Lrn, Lrp, 24n, 24p, 25n, 25p) referring to two given values for potential of the transmission signal and controlling the two respective resistors (N1, P1, N'1, P'1) of the resistance bridges (17, 17') of the receiver (12) and of the corresponding matching structure (15).

2. Method according to Claim 1, according to which the resistance bridge (17) determines a polarisation potential (Vtt) for the receiver.

3. Method according to Claim 2, according to which the adjustable resistors of the resistance bridge (17) are made respectively of two complementary types of transistors (N1, P1) in series between the two supply potentials (Vdd, Vss), each transistor having a gate-to-source voltage (Vgs) equal to the drain-to-source voltage (Vds) and their connections with the supply potentials being the inverse of those of the transistors of a CMOS-type inverter.

4. Method according to one of Claims 1 to 3, further consisting in causing the two given values for potential to correspond to the high and low levels (Vh, VI) of said transmission signal.

5. Method according to Claim 4, further consisting, for the obtaining of the given values for high and low levels, in taking one (VI) of these values and in determining the other value (Vh) relative to a third given value for voltage comprised between the two high and low levels and determined by the value of the polarisation potential (Vtt) of the receiver.

6. Method according to one of Claims 1 to 5, further consisting in connecting, within a matching unit (14) of the transmitter (11), the reference impedance (Rr) to a transmitter matching structure (16') reproducing the structure (16) of the transmitter (11).

7. Method according to Claim 6 according to which, since the structure (16) of the transmitter (11) includes a CMOS inverter (Ne, Pe) having complementary transistors, the reference impedance (Rr) is connected in series between the complementary transistors of an inverter (N'e, P'e) constituting the matching structure (16') of the matching unit (14) of the transmitter.

8. Method according to one of Claims 1 to 7, consisting in giving the reference impedance (Rr) a value that is twice that of the characteristic impedance of the line.

9. Method according to one of Claims 1 to 8, consisting in reproducing the structure (16) of the transmitter (11), including a CMOS inverter (Ne, Pe), within a matching structure (16') in a matching unit (14) of the transmitter, in connecting this matching structure (16') to the reference impedance (Rr) and in creating a closed-loop control (Len, Lep, 18n, 18p, 19n, 19p) referring to the two given values for potential of the transmission signal and controlling the two respective resistors (Ne, Pe, N'e, P'e) of the inverters (16, 16') of the transmitter (11) and the corresponding matching structure (16).

10. Method according to one of Claims 1 to 9, according to which the closed-loop control is digital.

11. Method according to one of the preceding claims, according to which the receiver is a CMOS-type inverter (Nr, Pr) polarised by the resistance bridge (17).

12. Method for matching impedance, in parallel, to the characteristic impedance (Zc) of a line (13) for transmitting a signal between a transmitter (11), which includes a CMOS inverter structure (16) made of two complementary transistors (Ne, Pe) in series, and a receiver (12), the method consisting in reproducing, in a matching unit (14) of the transmitter (11), the inverter (16) in a matching structure (16'), in connecting a reference impedance (Rr) in series between the two complementary transistors (N'e, P'e) of the matching structure (16') and in creating a closed-loop control (Len, Lep, 18n, 18p, 19n, 19p) referring to the two given values for potential of the transmission signal and controlling the two respective resistors (Ne, Pe, N'e, P'e) of the inverters (16, 16') of the transmitter (11) and of the corresponding matching structure (16).

13. Method according to Claim 12, consisting in giving the reference impedance (Rr) a value that is twice that of the characteristic impedance of the line.

14. Method according to Claim 12 or 13, consisting in causing the given values for potential of the high and low levels (Vh, VI) of said transmission signal to correspond, and in creating the closed-loop control on the values determined at corresponding points (A, B, C) of the matching structure.

15. Integrated circuit (IC) implementing the method as defined by one of the preceding claims, comprising a transmitter (11) and/or a receiver (12) intended respectively to be connected by at least one transmission line (13) to a receiver and/or to a corresponding transmitter, the receiver comprising a resistance bridge (17) formed of two adjustable resistors (N1, P1) in series between two supply potentials (Vdd, Vss) and in which the common point is connected to the input of the receiver (12), a matching unit (15) reproducing the resistance bridge (17) as two resistance bridges constituting a matching structure (17'), the two resistance bridges of the matching structure (17') being connected to the two respective ends of a reference impedance (Rr), a closed-loop control device (Lrn, Lrp, 24n, 24, 25n, 25p) for creating, within the matching unit (15) of the receiver (12), a closed-loop control (Lrn, Lrp, 24n, 24p, 25n, 25p) referring to two given values for potential of the transmission signal and for controlling the two respective resistors (N1, P1, N'1, P'1) of the resistance bridges (17, 17') of the receiver (12) and of the corresponding matching structure (15), and the transmitter comprising a CMOS inverter structure (16) made of two complementary transistors (Ne, Pe) in series, a matching unit (14) reproducing the inverter (16) as a matching structure (16'), a reference impedance (Rr) in series connected between the two complementary transistors (N'e, P'e) of the matching structure (16') and a closed-loop control device (Len, Lep, 18n, 18p, 19n, 19p) for creating, within the matching unit (14) of the transmitter (11), a closed-loop control (Len, Lep, 18n, 18p, 19n, 19p) referring to two given values for potential of the transmission signal and for controlling the two respective resistors (Ne, Pe, N'e, P'e) of the inverters (16, 16') of the transmitter (11) and of the corresponding matching structure (16).

16. Transmission system (SYS) comprising integrated circuits (IC1, IC2, IC3) incorporating transmitters and/or receivers and connected together by transmission lines (13), the system incorporating integrated circuits of the type defined by Claim 15.
